Europäisches Patentamt

European Patent Office

Office européen des brevets

(11) Veröffentlichungsnummer: **0 207 248 B1**

# EUROPÄISCHE PATENTSCHRIFT

(45) Veröffentlichungstag der Patentschrift: **13.11.91**

(21) Anmeldenummer: 86105670.3

(22) Anmeldetag: 24.04.86

(51) Int. Cl.⁵: **G01S 7/48**, G01S 7/28, H03K 5/08

(54) **Adaptiver Signaldetektor.**

(30) Priorität: 05.07.85 DE 3524021

(43) Veröffentlichungstag der Anmeldung:
07.01.87 Patentblatt 87/02

(45) Bekanntmachung des Hinweises auf die
Patenterteilung:
13.11.91 Patentblatt 91/46

(84) Benannte Vertragsstaaten:
**DE FR GB IT NL SE**

(56) Entgegenhaltungen:
EP-A- 0 113 892
DE-B- 1 229 143

**IEEE TRANSACTIONS ON INSTRUMENTA-
TION AND MEASUREMENT, Band IM-30, Nr. 4,
Dezember 1981, Seiten 299-301, IEEE, New
York, US; R. LUMIA: "A variable-threshold
digitizer for photodiode arrays"**

**PATENT ABSTRACTS OF JAPAN, Band 7, Nr.
129 (E-179)[1274], 4. Juni 1983; & 58 46 717
(NIPPON DENKI K.K.) 18-03-1983**

**IBM TECHNICAL DISCLOSURE BULLETIN,**

**Band 18, Nr. 10, März 1976, Seiten 3210-3212,
New York, US; S.S. CROW: "Comparator with
adaptive minimum threshold"**

(73) Patentinhaber: **ELTRO GmbH Gesellschaft für
Strahlungstechnik
Kurpfalzring 106 Postfach 10 21 20
W-6900 Heidelberg 1(DE)**

(72) Erfinder: **Welz, Wolfgang
Mühlenweg 2b
W-6900 Heidelberg 1(DE)**

(74) Vertreter: **Muschka, Wilhelm, Dipl.-Ing.
Eltro GmbH Gesellschaft für Strahlungstechnik Kurpfalzring 106 Postfach 10 21 20
W-6900 Heidelberg 1(DE)**

## Beschreibung

Die Erfindung bezieht sich auf ein Verfahren zum Empfang bestimmter Impulse nach dem Oberbegriff des Anspruchs 1 sowie auf eine Schaltungsanordnung zur Durchführung dieses Verfahrens.

Ein Verfahren und eine Schaltungsanordnung dieser Art sind aus der EP-A-0 113 892 (entspricht DE 32 47 137 C2)bekannt. Sie kommen für die Detektion von Signalstrukturen, die z.B. vom $CO_2$-TEA-Laser bekannt sind, vor allem aus folgendem Grund zum Einsatz:

Der Sendeimpuls von Pulsradaranlagen im 10 µm-Bereich besteht aus Haupt- und Nebenimpulsen; die Nebenimpulse folgen dem Hauptimpuls, z.B. in einem Abstand von $\geq$ 60 ns bis 100 ns, wobei die Schwerpunkte der Frequenzspektren um einen Faktor von ca. 3 bis 7 unterhalb des Hauptimpulsspektrums liegen. Da die radiale Auflösung bei hoher Signalempfindlichkeit ein wichtiges Leistungsmerkmal darstellt und bei den heutigen Einzelimpulssystemen unter 15 m ($\leq$ 100 ns) beträgt, ist zunächst eine Signalunterscheidung zwischen Hauptimpuls und Nebenimpulsen notwendig. Eine solche Unterscheidung ist mit dem bekannten Verfahren jedoch nicht mehr möglich, wenn z.B. zur Auflösungsverbesserung eine Pulsbreiten-Kompression im Kleinsignalbereich durchgeführt wird und dadurch im Großsignalbereich starke Impulsspektrumsverzerrungen entstehen. Eine Verstärkungsregelung innerhalb eines Meßintervalls ist wegen der nicht vorhersagbaren Empfangsleistung, die von Echo zu Echo sehr stark schwanken kann, meistens nicht möglich.

Der Erfindung liegt die Aufgabe zugrunde, den gattungsgemäßen Gegenstand auch dann nutzbar zu machen, wenn sich die Signalstrukturen in Abhängigkeit der Signalamplitude stark ändern. Diese Aufgabe wird bei dem Verfahren der eingangs beschriebenen Art erfindungsgemäß durch die im kennzeichnenden Teil des Anspruchs 1 angegebenen Merkmale gelöst. Von Vorteil ist hierbei, daß ein solches Verfahren unter absolut spezifizierten Grenzwerten ohne aufwendige Abgleichprozeduren zuverlässig sowie vergleichsweise preiswert realisierbar ist.

Eine Weiterbildung der Erfindung wird in der Schaltungsanordnung zur Durchführung des Verfahrens nach Anspruch 4 gesehen. Die Merkmale nach den Ansprüchen 3 und 6 reduzieren die Störwahrscheinlichkeit im übergangsbereich von Groß- zu Kleinsignalbetrieb. Die restlichen Unteransprüche enthalten zusätzliche Weiterbildungen der Erfindung.

Im folgenden wird an Hand einer Zeichnung ein Ausführungsbeispiel der Erfindung näher erläutert, wobei die in den beiden Figuren einander entsprechenden Teile dieselben Bezugszeichen aufweisen. Es zeigt

Fig. 1    die erfindungsgemäße Schaltungsanordnung als Blockschaltbild und

Fig. 2    relative Signalamplituden in der oberen Bildhälfte und Impulsdiagramme an ganz bestimmten Punkten der Schaltungsanordnung von Fig. 1 in der unteren Bildhälfte.

An den Eingängen des Analogverzögerungsgliedes 1, des Signal-Dämpfungsgliedes 2 sowie eines ersten Differenzdiskriminators 4 liegt der Impuls e an. Die strichpunktierten Umrandungen 8 symbolisieren jeweils einen Konstant-Bruchteil-Diskriminator, der aus dem Analog-Verzögerungsglied 1, dem mit einem Däpfungsfaktor A versehenen Signal-Dämpfungsglied 2 und einem zweiten Differenzdiskriminator 3 besteht. Das Analog-Verzögerungsglied leitet den Impuls e mit gleicher Amplitudenhöhe und -breite, jedoch zeitverzögert, als Impuls a an einen Eingang des zweiten Differenzdiskriminators 3, während das Signal-Dämpfungsglied 2 den Impuls durch den Dämpfungsfaktor A teilt und ihn als Impuls b an einen anderen Eingang dieses Diskriminators leitet. Von hier aus gelangt der Impuls C an die Logik 5 sowie unter Berücksichtigung des von dem ersten Differenzdiskriminator 4 an die Logik übermittelten Signals $D_1$ als Signal Q an die weitere, zeichnerisch nicht dargestellte Verarbeitung. Die Logik wird nur dann getriggert, wenn $D_1$ und die positive Flanke C vorhanden sind. Der Teilungsfaktor und die Zeitverzögerung müssen so gewählt sein, daß bei den infrage kommenden Impulsen (mit stark schwankenden Amplituden, ineinandergeschobenen oder dicht aneinandergereihten Impulsen mit im Verhältnis zum Anstieg größerer Impulsbreite, anders gearteter Abfallflanke und gegebenenfalls Überlagerung höherfrequenter Signalanteile mit geringer Amplitude) die Rückflanke keinen weiteren Trigger auslöst, falls kein zweiter Impuls in dem Zeitraum der Abfallflanke vorhanden ist. Außerdem muß der Pulsdetektor einen solchen Triggerpegel aufweisen, daß die Störwahrscheinlichkeit einen vordefinierten Wert nicht überschreitet.

Mit einer weiteren strichpunktierten Linienführung ist die aus den beiden Regeleinrichtungen 6 und 7 bestehende Automatik 9 für eine maximale Detektionsempfindlichkeit bezeichnet. Erstere ist zur Nullpunktkorrektur zwischen den Ausgang und einen Offsetstelleingang des zweiten Differenzdiskriminators 3 geschaltet und reduziert die Offsetfehler auf ein Minimum. Das regelnde Signal ist $y_o$. Zwischen Aus- und Eingang des ersten Differenzdiskriminators 4 ist die andere Regeleinrichtung geschaltet; sie dient als Störwahrscheinlichkeits-Regelschaltung, deren Signal $y_s$ dem Diskriminator Đals Triggerschwelle so zugeführt wird, daß die Störwahrscheinlichkeit einen vordefinierten Wert nicht überschreitet. Insoweit handelt es sich um einen Signaldetektor von bekanntem Stand der Technik.

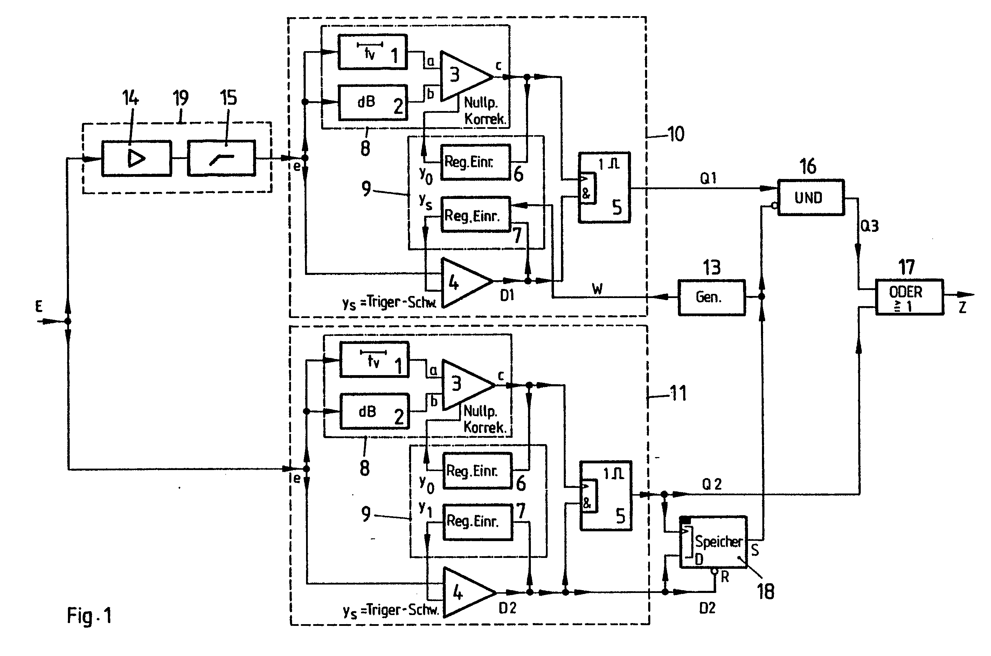

Die aus einer unterbrochenen Linienführung bestehenden Umrandungen 10 und 11 von Fig. 1 beinhalten je einen solchen Signaldtektor. Diese beiden Detektoren sind untereinander parallel geschaltet. Die an ihren Eingängen e anstehenden Signale sind lediglich dann unterschiedlicher Natur, sofern die nicht obligatorische, aus dem Verstärker 14 und dem Begrenzer 15 bestehende Baugruppe 19 vorgesehen ist, was von verschiedenen Randparametern abhängt, jedoch im anstehenden Zusammenhang von untergeordneter Bedeutung ist. Deshalb sowie aus Gründen der Beschreibungsvereinfachung soll im folgenden davon ausgegangen werden, daß trotz der angedeuteten Baugruppe 19 an den Eingängen e gleiche Signale anstehen.

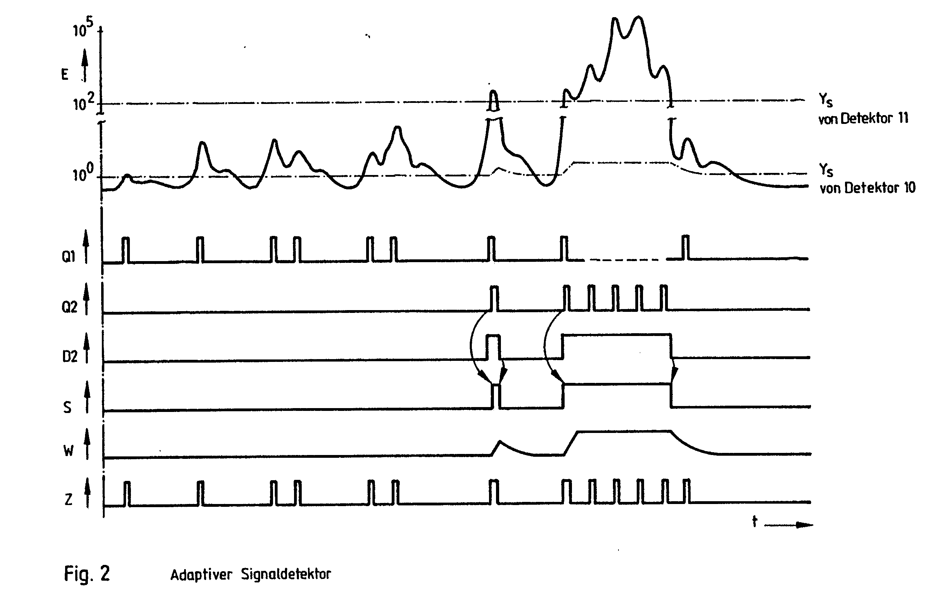

Das Verhältnis der geteilten zur verzögerten Amplitude und die Verzögerungszeit des ersten Signaldetektors 10 sind so bemessen, daß die Vorderflanke der Signale im Kleinsignal optimal detektiert und die Nebensignale (Schwanzanteile) auf der abfallenden Flanke unterdrückt werden. Bei dem weiteren Signaldetektor 11 dagegen sind Amplitudenverhältnis und Verzögerungszeit so eingestellt, daß alle Impulse im Signal bereich (Fig. 2) bei Großsignalsteuerung erkannt werden. Bei dem weiteren Signaldetektor 11 und gegebenenfalls noch anderen zu ihm parallel geschalteten Detektoren kann die Regeleinrichtung auch ganz entfallen.

Für den Kleinsignalbereich gilt nun, daß die Triggerschwelle $y_s$ des weiteren Signaldetektors 11 vom ersten Differenzdiskriminator 4 nicht überschritten wird, so daß nur der erste Signaldetektor 10 wirksam ist. Dieses Ausgangssignal $Q_1$ wird über das UND-Gatter 16 und das ODER-Gatter 17 zum Ausgang Z durchgeschaltet.

Erreicht dagegen der Signalpegel am Eingang e die Triggerschwelle $y_s$ des ersten Differenzdiskriminators 4, so schaltet ein vom weiteren Signaldetektor 11 erkanntes Signal über das Videosignal $Q_2$ den Ausgang S des Speichers 18 auf logisch 1, nachdem dieser Speicher zuvor über das Ausgangssignal $D_2$ des ersten Differenzdiskriminators 4 vorbereitet worden war.

Das Videosignal $Q_2$ erreicht über das ODER-Gatter 17 und parallel zum Signal $Q_1$ den Ausgang Z. Letzteres Signal wird nun durch das Ausgangssignal S des Speichers 18 über das UND-Gatter 16 zum Ausgang Z getrennt. Außerdem erzeugt der Hilfs-Führungsgrößen-Generator 13 für die Regeleinrichtung 7 des ersten Signaldetektors 10 ein erstes Steuersignal W, das die Triggerschwelle $y_s$ dieses Detektors um einen definierten Wert erhöht. Solang das Eingangssignal E über dem Triggerpegel $Y_s$ des weiteren Signaldetektors 11 liegt, übernimmt es auch die Signaldetektion. Hierbei handelt es sich um Großsignalbetrieb.

Fällt nun aber das Eingangssignal E unter die Triggerschwelle $y_s$ des weiteren Signaldetektors 11, so wird der Speicher 18 über das Ausgangssignal $D_2$ des ersten Differenzdiskriminators 4 zurückgesetzt, das Ausgangssignal $Q_1$ des ersten Signaldetektors 10 über das UND-Gatter 16 zum Ausgang Z durchgeschaltet und der Hilfs-Führungsgrößen-Generator 13 getriggert. Letzterer erzeugt ein zweites Steuersignal W für die Regeleinrichtung 7 des ersten Signaldetektors 10, das sodann die erhöhte Triggerschwelle $y_s$ dieses Detektors in einer vorprogrammierten Zeitfunktion auf das ursprüngliche Maß zurücknimmt.

In Fig. 2 sind in einer Art Zusammenfassung die Ergebnisse der einzelnen Schaltvorgänge des Blockschaltbildes gemäß Fig. 1 untereinander aufgereiht. Dabei wurden in der oberen Bildhälfte zur Verdeutlichung der Dynamik die relativen Amplituden eines komplexen Eingangssignals E festgehalten, während darunter und hiervon abhängig die Impulsdiagramme $Q_1$, $Q_2$, $D_2$, S, W und Z dargestellt sind. Letztere entsprechen dabei den einzelnen Rechenoperationen, wie sie sich in der Schaltungsanordnung gemäß Fig. 1 an den Ausgängen der Signaldetektoren 10 und 11, des Differenzdiskriminators des weiteren Signaldetektors 11, des Speichers 18, des Hilfs-Führungsgrößen-Generators 13 und des Schaltungsausgangs ergeben: Das Impulsdiagramm $Q_1$ zeigt alle Impulse oberhalb der Triggerschwelle $y_s$ des ersten Signaldetektors 10, während dasjenige von $Q_2$ nur noch die Impulse oberhalb der Triggerschwelle $Y_s$ des weiteren Signaldetektors 11 berücksichtigt. Das Impulsdiagramm von $D_2$ ergibt sich am Ausgang des ersten Differenzdiskriminators 4 des weiteren Signaldetektors 11. Das Impulsdiagramm S entsteht immer, wenn mit ansteigender Flanke von $Q_2$ eingeschaltet und mit abfallender Flanke von $D_2$ abgeschaltet wird. Zu denselben Ein- und Ausschaltvorgängen entsteht auch das Impulsdiagramm W des Hilfe-Führungsgrößen-Generators 13, während Z das Impulsdiagramm am Ausgang der erfindungsgemäßen Schaltungsanordnung wiedergibt.

Bei einem anderen, zeichnerisch nicht dargestellten Ausführungsbeispiel ist es auch denkbar, zu einer Signalerkennung mehr als zwei Signaldetektoren untereinander parallel zu schalten.

## Patentansprüche

1. Verfahren zum Empfang von in ihrer Amplitude stark schwankenden, dicht aufeinander folgenden oder ineinander geschobenen Impulsen mit im Verhältnis zur Anstiegsflanke großer Impulsbreite und gegebenenfalls einer überlagerung höherfrequenter Signalanteile mit geringer Amplitude, wobei

a) für die elektronische Auswertung nur die Anstiegsflanke der Signalamplitude verwendet und die anders geartete Abfallflanke unterdrückt wird, sofern im Bereich der zuletztgenannten Flanke kein zweites Signal vorhanden ist,

b) in einem ersten Signaldetektor (10) das Signal sowohl zum Eingang eines ersten Differenzdiskriminators (4) geführt als auch in einem Konstant-Bruchteil-Diskriminator (8) in einem bestimmten Verhältnis geteilt und parallel dazu verzögert wird und beide resultierenden Signalamplituden in einem zweiten Differenzdiskriminator (3) miteinander verglichen werden,

c) die Triggerschwelle des ersten Differenzdiskriminators (4) in Abhängigkeit von der durch Rauschen bewirkten Störwahrscheinlichkeit auf einen bestimmten Wert geregelt wird, das Ausgangssignal des ersten Differenzdiskriminators (4) einen monostabilen Multivibrator (5) freigibt, das Ausgangssignal des Konstant-Bruchteil-Diskriminators (8) den monostabilen Multivibrator (5) triggert, das Ausgangssignal des ersten Signaldetektors (10) das Ausgangssignal des monostabilen Multivibrators (5) ist, und

d) an den Ausgängen des ersten Differenzdiskriminators (4) und des Konstant-Bruchteil-Diskriminators (8) je eine Regeleinrichtung (7 bzw. 6) mit ihrem einen Ende anliegt, während das andere Ende der dem Konstant-Bruchteil-Diskriminator (8) zugeordneten Regeleinrichtung (6) an seinem Offsetstelleingang und das andere Ende der dem ersten Differenzdiskriminator (4) zugeordneten Regeleinrichtung (7) am Bezugseingang anliegt,

**dadurch gekennzeichnet, daß**

e) zu dem im wesentlichen aus den beiden einstellbaren und über den monostabilen Multivibrator (5) miteinander verknüpften Diskriminatoren (4; 8) bestehenden ersten Signaldetektor (10) wenigstens ein in der Struktur gleicher weiterer Signaldetektor (11) parallel geschaltet wird,

f) für den Fall, daß der Eingangssignalpegel die Triggerschwelle ($y_s$) des weiteren Signaldetektors (11) erreicht und dieser eine Anstiegsflanke vom Eingangssignal detektiert, das Ausgangssignal ($Q_1$) des ersten Signaldetektors (10) vom Ausgang (Z) getrennt, die Triggerschwelle ($y_s$) des ersten Signaldetektors (10) um einen definierten Wert erhöht und für die Zeit des Darüberliegens des Eingangssignales über der Triggerschwelle des weiteren Signaldetektors (11) das Eingangssignal mit dem weiteren Signaldetektor (11) detektiert wird (Großsignalbereich) und

g) für den Fall des Absinkens des Eingangssignal-Pegels unter die Triggerschwelle ($y_s$) des weiteren Signaldetektors (11), das Ausgangssignal ($Q_1$) des ersten Signaldetektors (10) wieder zum Ausgang (Z) durchgeschaltet und seine erhöhte Triggerschwelle ($y_s$) in einer vorprogrammierten Zeitfunktion auf das ursprüngliche Maß reduziert wird (Kleinsignalbereich).

2. Verfahren nach Anspruch 1, **dadurch gekennzeichnet,** daß im Fall des Erreiches und/oder überschreitens der Triggerschwelle ($y_s$) des weiteren Signaldetektors (11) mittels des Ausgangssignals seines monostabilen Multivibrators (5) ein über ein Verknüpfungsglied (16) an den Ausgang des ersten Signaldetektors (10) gekoppelter Speicher (18) auf logisch 1 geschaltet wird.

3. Verfahren nach Anspruch 1, **dadurch gekennzeichnet,** daß mit einem Hilfs-Führungsgrößen-Generator (13) über einen separaten Steuereingang der Regeleinrichtung (7) die Triggerschwelle ($y_s$) des ersten Signaldetektors (10) bei Großsignalbetrieb um einen definierten Wert erhöht und bei Kleinsignalbetrieb in vorprogrammierter Zeitfunktion auf das ursprüngliche Maß zurückgenommen wird.

4. Schaltungsanordnung zur Durchführung des Verfahrens nach Anspruch 1, enthaltend

a) einen ersten Signaldetektor (10), bei dem nur die Anstiegsflanke der Signalamplitude von Signal e sowohl zum Eingang des ersten Differenzdiskriminators (4) gelangt als auch zu einem Konstant-Bruchteil-Diskriminator (8), in dem sie in einem bestimmten Verhältnis geteilt und parallel dazu verzögert wird, und anschließend beide resultierende Signalamplituden in einem zweiten Differenzdiskriminator (3) miteinander verglichen werden, während die anders geartete Abfallflanke unterdrückt wird, sofern im Bereich der zuletztgenannten Flanke kein zweites Signal vorhanden ist.

b) eine Triggerschwelle des ersten Differenzdiskriminators (4), die in Abhängigkeit von der durch Rauschen bewirkten Störwahrscheinlichkeit auf einen bestimmten Wert geregelt wird, sowie den monostabilen Multivibrator (5), der einmal durch das Ausgangssignal des ersten Differenzdiskriminators (4) freigegeben und zum anderen durch das Ausgangssignal des Konstant-Bruchteil-Diskriminators (8) getriggert wird, wobei das Ausgangssignal des ersten Signaldetektors (10) das Ausgangssignal des monostabilen Multivibrators (5) ist,

c) je eine Regeleinrichtung (6; 7), die mit ihrem einen Ende an den Ausgängen des ersten Differenzdiskriminators (4) und des Konstant-Bruchteil-Diskriminators (8) anliegen, während das andere Ende der dem Konstant-Bruchteil-Diskriminator (8) zugeordneten Regeleinrichtung (6) an seinem Offsetstelleingang und das andere Ende der dem ersten Differenzdiskriminator (4) zugeordneten Regeleinrichtung (7) am Bezugseingang anliegt

**gekennzeichnet** durch

d) wenigstens einen in der Struktur ebenso wie der erste Signaldetektor (10) ausgebildeten und zu diesem parallel geschalteten weiteren Signaldetektor (11),
e) ein Signal E, das an den Eingängen (e) aller Signaldetektoren anliegt, deren Ausgänge abschaltbar ausgebildet sind,
f) eine Trennung des Ausgagssignals $(Q_1)$ des ersten Signaldetektors (10) von Ausgang (Z) für denjenigen Fall, daß der Eingangssignalpegel die Triggerschaltung $(y_s)$ des weiteren Signaldetektors (11) erreicht und dieser eine Anstiegsflanke vom Eingangssignal detektiert; eine Erhöhung seiner Triggerschwelle $(y_s)$ um einen definierten Wert und ein Detektieren des Eingangssignals mit dem weiteren Signaldetektor (11) für die Zeit des Darüberliegens des Eingangssignals über der Triggerschwelle des weiteren Signaldetektors (11) und
g) eine Durchschaltmöglichkeit des Ausgangssignals $(Q_1)$ des esten Signaldetektors (10) zum Ausgang (Z) sowie eine Reduzierung der erhöhten Triggerschwelle $(y_s)$ in einer vorprogrammierten Zeitfunktion mit Hilfe eines separaten Steuereingangs (W) an der Regeleinrichtung (7) dieses Detektors für den Fall des Absinkens des Eingangssignal-Pegels unter die Triggerschwelle $(y_s)$ des weiteren Signaldetektors (11).

5. Schaltungsanordnung nach Anspruch 4, **dadurch gekennzeichnet,** daß das Eingangssignal (E) über einen Verstärker (14) und einen Begrenzer (15) an den Eingang (e) des ersten Signaldetektors (10) gelangt.

6. Schaltungsanordnung nach Anspruch 4, **dadurch gekennzeichnet,** daß der separate Steuereingang (12) über einen Hilfs-Führungsgrößen-Generator (13) betätigbar ist.

7. Schaltungsanordnung nach Anspruch 4, 5 oder 6, **dadurch gekennzeichnet,** daß das Ausgangssignal $(Q_1)$ des ersten Signaldetektors (10) über ein UND-Gatter und ein ODER-Gatter (17), und die Ausgangssignale des weiteren Signaldetektors (11) nur über das ODER-Gatter (17) an den Ausgang (A) gelangen.

8. Schaltungsanordnung nach Anspruch 4, 5, 6 oder 7, **dadurch gekennzeichnet,** daß die Anstiegsflanke des Videosignals $(Q_2)$ der weiteren Signaldetektoren (11) den über das Ausgangssignal $(D_2)$ des jeweils zugehörigen ersten Differenzdiskriminators (4) vorbereiteten und ausgangseitig mit dem Eingang des UND-Gatters (16) verbundenen Speicher (18) solange einschaltet, wie das jeweilige Ausgangssignal $(D_2)$ vorhanden (logisch 1) ist.

**Claims**

1. Method of receiving pulses which follow one another in short intervals or are merged with one another and the amplitude of which fluctuates strongly, with a wide pulse width relative to the ascending flank and where appropriate an overlapping of signal components of higher frequency with a low amplitude, whereby

a) for electronic analysis only the ascending flank of the signal amplitude is used and the different descending flank is suppressed, if there is no second signal in the region of the descending flank,
b) in a first signal detector (10) the signal is fed to the input of a first differential discriminator (4) and is also divided and delayed parallel thereto in a constant-fraction-discriminator (8) in a predetermined relationship and both resulting signal amplitudes are compared with one another in a second differential discriminator (3),
c) the trigger threshold of the first differential discriminator (4) is regulated to a predetermined value dependent upon the likelihood of noise disturbance, the output signal of the first differential discriminator (4) enables a monostable multivibrator (5), the output signal of the constant-fraction-discriminator (8) triggers the monostable multivibrator (5), the output signal of the first signal detector (10) is the output signal of the monostable multivibrator (5), and

d) at the outputs of the first differential discriminator (4) and the constant-fraction-discriminator (8) there abuts in each case one regulating device (7 or 6) with one end thereof, whereas the other end of the regulating device (6) which is associated with the constant-fraction-discriminator (8) abuts on its offset adjusting input, and the other end of the regulating device (7) which is associated with the first differential discriminator (4) abuts on the reference input,

characterised in that

e) to the first signal detector (10), which consists essentially of the two adjustable discriminators (4; 8) which can be interconnected via the monostable multivibrator (5), there is connected in parallel at least one further signal detector (11) having the same structure;

f) if the input signal level reaches the trigger threshold $(y_s)$ of the further signal detector (11) and the latter detects an ascending flank of the input signal, the output signal $(Q_1)$ of the first signal detector (10) is disconnected from the output (Z), the trigger threshold $(y_s)$ of the first signal detector (10) is increased by a predetermined value and the input signal is detected by the further signal detector (11) (large signal range) during the time when the input signal is higher than the trigger threshold of the further signal detector (11) and

g) if the input signal level decreases below the trigger threshold $(y_s)$ of the further signal detector (11), the output signal $(Q_1)$ of the first signal detector (10) is again switched through to the output (Z) and its increased trigger threshold $(y_s)$ is reduced to the initial value in a pre-programmed time function (small signal range).

2. Method according to claim 1, characterised in that, if the trigger threshold $(y_s)$ of the further signal detector (11) is reached and/or exceeded, a storage device (18) which is coupled to the output of the first signal detector (10) via connecting means (16) is switched to logic 1 by the output signal of the monostable multivibrator (5) of the signal detector (11).

3. Method according to claim 1, characterised in that in the case of large signal operation the trigger threshold $(y_s)$ of the first signal detector (10) is increased by a predetermined value by means of an auxiliary reference input generator (13) via a separate control input of the regulating device (7) in the case of large signal operation and in the case of small signal operation it is decreased to the initial value in the pre-programmed time function.

4. Circuit arrangement for carrying out the method of claim 1, comprising

a) a first signal detector (10), by which only the ascending flank of the signal amplitude of signal e reaches the input of the first differential discriminator (4) and also a constant-fraction-discriminator (8) in which it is separated in a predetermined ratio and delayed parallel thereto, and subsequently both resulting signal amplitudes are compared to one another in a second differential discriminator (3), whereas the different descending flank is suppressed if there is no second signal in the region of the last-mentioned flank;

b) a trigger threshold of the first differential discriminator (4), which is regulated to a predetermined value dependent upon the likelihood of noise disturbance, and also the monostable multivibrator (5) which is enabled on the one hand by the output signal of the first differential discriminator (4) and on the other hand is triggered by the output signal of the constant-fraction-discriminator (8), whereby the output signal of the first signal detector (10) is the output signal of the monostable multivibrator (5),

c) one regulating device (6; 7) in each case which abuts with its one end on the outputs of the first differential discriminator (4) and of the constant-fraction-discriminator (8), whereas the other end of the regulating device (6) which is associated with the constant-fraction-discriminator (8) abuts on its offset adjusting input, and the other end of the regulating device (7) which is associated with the first differential discriminator (4) abuts on the reference input,

characterised by

d) at least one further signal detector (11) which has the same structure as the first signal detector (10) and is connected in parallel thereto,

e) a signal e, which is on the inputs (e) of all signal detectors, the outputs of which are arranged so that they can be switched off,

f) a disconnection of the output signal $(Q_1)$ of the first signal detector (10) from output (Z) if the input signal level reaches the trigger circuit $(y_s)$ of the further signal de-

EP 0 207 248 B1

tector (11) and the latter detects an ascending flank of the input signal, a rise of its trigger threshold ($y_s$) by a defined value and detecting the input signal by means of the further signal detector (11) for the time during which the input signal exceeds the trigger threshold of the further signal detector (11) and

g) the possibility of switching the output signal ($Q_1$) of the first signal detector (10) through to the output (Z) and also a reduction of the increased trigger threshold ($y_s$) in a pre-programmed time function by means of a separate control input (W) on the regulating device (7) of this detector, if the input signal level falls below the trigger threshold ($y_s$) of the further signal detector (11).

5. Circuit arrangement according to claim 4, characterised in that the input signal (E) reaches the input (e) of the first signal detector (10) via an amplifier (14) and a limiter (15).

6. Circuit arrangement according to claim 4, characterised in that the separate control input (12) is actuable via an auxiliary reference input generator (13).

7. Circuit arrangement according to claim 4, 5 or 6, characterised in that the output signal ($Q_1$) of the first signal detector (10) reaches the output (A) via an AND-gate and an OR-gate (17), and the output signals of the further signal detector (11) reach the output (A) only via the OR-gate (17).

8. Circuit arrangement according to claim 4, 5, 6 or 7, characterised in that the ascending flank of the video signal ($Q_2$) of the further signal detectors (11) enables the storage device (18) for as long as the respective output signal ($D_2$) is present (is at logic 1), the storage device being primed via the output signal ($D_2$) of the respectively associated first differential discriminator (4) and connected on the output side to the input of the AND-gate (16).

**Revendications**

1. Procédé de réception d'impulsions ayant de fortes variations d'amplitude, se suivant l'une l'autre de près ou emboîtées l'une dans l'autre, ayant par rapport au front de montée une grande largeur d'impulsion et éventuellement une superposition de parties de signaux de fréquence plus élevée et d'amplitude moindre, cependant que :

a) pour l'exploitation électronique, seul le front de montée de l'amplitude du signal est utilisé et les fronts de descente d'allure différente sont supprimés de telle sorte que dans le domaine du front nommé en dernier aucun deuxième signal ne soit disponible,

b) dans un premier détecteur de signal (10) le signal est non seulement amené à l'entrée d'un premier discriminateur différentiel (4) mais encore réparti dans une proportion déterminée dans un discriminateur constant en pont et, en parallèle, est retardé et les amplitudes des deux signaux résultants sont comparées l'une avec l'autre dans un second discriminateur différentiel (3),

c) le seuil de déclenchement du premier discriminateur différentiel (4) est réglé à une valeur déterminée en fonction de la probabilité de perturbation provoquée par le bruit, le signal de portie du premier discriminateur différentiel (4) débloque un multivibrateur monostable (5), le signal de sortie du discriminateur constant en pont (8) déclenche le multivabrateur monostable (5), le signal de sortie du premier détecteur de signal (10) est le signal de portie du multivibrateur monostable (5), et

d) aux sorties du premier discriminateur différentiel (4) et du discriminateur constant en pont (8) un dispositif de réglage (7 ou 6 respectivement) est par une de ses extrémités, tandis que l'autre extrémité du dispositif de réglage (6) associé au discriminateur constant en pont, est située à son entrée de réglage du décalage et l'autre extrémité du dispositif de réglage (7) associé au premier discriminateur différentiel (4) est situé à l'entrée de référence, caractérisé en ce que :

e) au premier détecteur de signal (10) constitué essentiellement des deux discriminateurs (4,8) réglables et reliés l'un à l'autre par l'intermédiaire du multivibrateur monostable (5) au moins un autre détecteur de signal (11) de structure similaire est raccordé en parallèle,

f) au cas où le niveau du signal d'entrée atteint le seuil de déclenchement (ys) de l'autre détecteur de signal (11) et que ce dernier détecte un front de montée à partir du signal d'entrée, le signal de sortie (Q1) du premier détecteur de signal (10) est séparé de la sortie (Z), le seuil de déclenchement (ys) du premier détecteur de signal (10) est augmenté d'une valeur définie et pour le temps où le signal d'entrée dépasse le seuil de déclenchement de l'autre détecteur de signal (11), le signal d'entrée est détecté avec l'autre détecteur de signal (11) (domaine des grands signaux) et

g) en cas de baisse du niveau du signal d'entrée au-dessous du seuil de déclenchement (ys) de l'autre détecteur de signal (11), le signal de sortie (Q1) du premier détecteur de signal (10) est relié de nouveau à la sortie (Z) et sa valeur augmentée de seuil de déclenchement (ys) est réduite dans une fonction de temps pré-programmée à sa valeur d'origine (domaine des petits signaux).

2.    Procédé selon la revendication 1, caractérisé en ce qu'au cas où le seuil de déclenchement (ys) de l'autre détecteur de signal (11) est atteint et/ou dépassé, une mémoire (18) couplée par l'intermédiaire d'un élément de raccordement (16) à la sortie du premier détecteur de signal (10), est commutée à l'état logique 1 au moyen du signal de sortie de son multivibrateur monostable (5).

3.    Procédé selon la revendication 1, caractérisé en ce qu'au moyen d'un générateur auxiliaire de grandeurs de référence (13) sur une entrée de commande séparée du dispositif de réglage (7) le seuil de déclenchement (ys) du premier détecteur de signal (10) est augmenté, en cas de fonctionnement dans le domaine des grands signaux, d'une valeur définie et, en cas de fonctionnement dans le domaine des petits signaux, est ramené dans une fonction de temps pré-programmée à sa valeur d'origine.

4.    Disposition de circuit en vue de la mise en oeuvre du procédé selon la revendication 1, comprenant

a) un premier détecteur de signal (10) dans lequel seulement le front de montée de l'amplitude du signal arrive à la fois à l'entrée du premier discriminateur différentiel (4) et à un discriminateur consistant en pont (B) dans lequel il est réparti dans un rapport déterminé et, retardé en parallèle et immédiatement après les deux amplitudes de signaux résultantes sont comparées l'une avec l'autre dans un deuxième discriminateur différentiel (3), tandis que les fronts de descente d'allure différente sont supprimés de telle sorte que dans le domaine du front nommé en dernier aucun deuxième signal ne soit disponible,

b) un seuil de déclenchement du premier discriminateur différentiel (4) qui est réglé à une valeur déterminée en fonction de la probabilité de perturbation provoquée par le bruit, ainsi que le multivibrateur monostable (5) qui est une fois débloqué par le signal de sortie du premier discriminateur différentiel (4) et une autre fois déclenché par le signal de sortie du discriminateur constant en pont (8), le signal de sortie du premier détecteur de signal (10) étant le signal de sortie du multivibrateur monostable (5),

c) un dispositif de réglage (6 ou 7) qui est situé par l'une de ses extrémités respectives aux sorties du premier discriminateur différentiel (4) et du discriminateur constant en pont (8), tandis que l'autre extrémité du dispositif de réglage (6) associé au discriminateur constant en pont (8) est située à son entrée de réglage du décalage, et que l'autre extrémité du dispositif de réglage (7) associé au premier discriminateur différentiel (4) est située à l'entrée de référence caractérise par :

d) au moins un autre détecteur de signal (11) de structure analogue à celle du premier détecteur de signal (10) et branché en parallèle avec lui,

e) un signal E, qui est appliqué aux entrées (e) de tous les détecteurs de signal dont les sorties sont conçues pour être commutables,

f) une séparation du signal de sortie (Q1) du premier détecteur de signal (10) de la sortie (Z), pour les cas où le niveau du signal d'entrée atteint le seuil de déclenchement (ys) de l'autre détecteur de signal (11) et où celui-ci détecte un front de montée du signal d'entrée ; une augmentation de son seuil de déclenchement (ys) d'une valeur définie et une détection du signal d'entrée avec l'autre détecteur de signal (11) pour le temps pendant lequel le signal d'entrée dépasse le seuil de déclenchement du deuxième détecteur de signal (11) et

g) une possibilité de transmission du signal de sortie (Q1) du premier détecteur de signal (10) vers la sortie (Z) en même temps qu'une réduction du seuil de déclenchement augmenté (ys) dans une fonction de temps pré-programmée au moyen d'une entrée de commande séparée (W) au dispositif de réglage (7) de ce détecteur en cas de décroissance du niveau du signal d'entrée au-dessous du seuil de déclenchement (ys) de l'autre détecteur de signal (11).

5.    Disposition de circuit selon la revendication 4 caractérisée en ce que le signal d'entrée (E) arrive par l'intermédiaire d'un amplificateur (14) et d'un limiteur (15) à l'entrée (e) du premier détecteur de signal (10).

6.    Disposition de circuit selon la revendication 4, caractérisé en ce que l'entrée de commande néparée (12) peut être actionnée par l'intermédiaire d'un générateur auxiliaire de grandeurs de référence (13).

7. Disposition de circuit selon la revendication 4, 5 ou 6 caractérisée en ce que le signal de sortie (Q1) du premier détecteur de signal (10) arrive sur une porte ET (16) et une porte OU (17), et que les signaux de sortie de l'autre détecteur de signal (11) arrivent seulement par l'intermédiaire de la porte OU (17) à la sortie (A).

8. Disposition de circuit selon la revendication 4, 5, 6 ou 7 caractérisée en ce que le front de montée du signal vidéo (Q2) des autres détecteurs de signal (11) maintient connectée la mémoire (18), activée au moyen du signal de sortie (D2) du premier discriminateur différentiel (4) qui, de temps en temps, lui est associé, et reliée du côté de la sortie à l'entrée de la porte ET (16), tant que le signal de sortie respectif (D2) est disponible (1 logique).

Fig.1

Fig. 2    Adaptiver Signaldetektor

EP 0 207 248 B1